# FASCICULE DE BREVET EUROPEEN

(11) **EP 0 837 370 B1**
(45) Date de publication et mention de la délivrance du brevet: **12.12.2001**
(21) Numéro de dépôt: 97402439.0
(22) Date de dépôt: 15.10.1997
(51) Int. Cl.: G03F 7/20

(54) **Machine pour insoler des plaques en photopolymère pour l'impression flexographique**
Belichtungsgerät für Flexodruckplatten
Exposure apparatus for flexographic printing plates

(30) Priorité: 16.10.1996 FR 9612635
(43) Date de publication de la demande: 22.04.1998
(73) Titulaire: ROLLIN S.A., F-68700 Cernay (FR)
(72) Inventeur: Barral, Christian, 68700 Uffholtz (FR); Cattani, Giorgio, 29100 Piacenza (IT); Crespi, Flaviano, 20020 Villa Cortese (IT); Schanen, Michel, 68116 Guewenheim (FR)
(74) Mandataire: Bentz, Jean-Paul

(56) Documents cités:
- EP-A- 0 480 073
- DE-A- 3 829 555
- DE-U- 9 003 438
- FR-A- 2 522 532
- US-A- 3 604 798
- PATENT ABSTRACTS OF JAPAN vol. 014, no. 104 (P-1013), 26 février 1990 & JP 01 307758 A (TOSHIBA CORP), 12 décembre 1989,

## Description

La présente invention a essentiellement pour objet une machine perfectionnée pour insoler des plaques en photopolymère pour l'impression flexographique.

On a déjà proposé des machines aptes à réaliser l'insolation de plaques en photopolymère à l'aide d'une source de lumière ultraviolette.

D'une manière générale, ces machines comprennent un châssis au-dessus duquel est agencée au moins une rampe de lampes ultraviolettes.

On place sur la partie supérieure du châssis, en dessous de la rampe de lampes ultraviolettes, une plaque en photopolymère qui est insolée par les lampes au travers d'un film négatif disposé sur la plaque. L'ensemble film-plaque est maintenu sous vide sur la partie supérieure du châssis de la machine à l'aide d'une membrane transparente.

Or, il a été constaté que l'énergie des lampes ultraviolettes chauffe l'espace défini par la membrane transparente et la partie supérieure du châssis de la machine, c'est-à-dire l'espace contenant le film négatif et la plaque flexographique.

Il en résulte que, malgré le vide dans cet espace, ce dernier forme une poche de gaz qui conduit à la séparation ou à la désolidarisation de la plaque flexographique du film négatif.

On se trouve par conséquent dans de mauvaises conditions d'insolation, de sorte qu'on obtient finalement une plaque d'impression qui est floue.

Plus précisément, après insolation de la plaque dans les mauvaises conditions indiquées ci-dessus, et après lavage au solvant de cette plaque insolée, on constate qu'il y a une mauvaise définition ou résolution du relief de la plaque produit par la lumière ultraviolette qui soit traverse les zones transparentes du film négatif soit est arrêtée par les zones opaques de ce film, de sorte que finalement l'impression procurée par cette plaque après encrage sera floue.

Aussi, la présente invention a pour but de remédier à ces inconvénients en proposant une machine perfectionnée grâce à laquelle la plaque flexographique à insoler ne subira aucune perturbation due à la chaleur des lampes à lumière ultraviolette.

A cet effet, l'invention a pour objet une machine perfectionnée pour insoler des plaques en photopolymère pour l'impression flexographique, et du type comprenant un châssis au-dessus duquel et située au moins une source de lumière ultraviolette susceptible d'insoler une plaque en photopolymère, reposant sur ledit châssis, à travers un film négatif maintenu sous vide avec ladite plaque sur le châssis à l'aide d'une membrane transparente, caractérisée en ce qu'elle est munie d'au moins un appareil de refroidissement de la partie supérieure du châssis comportant l'ensemble membrane-film négatif-plaque en photopolymère conformément aux revendications 1 et 2.

Suivant un exemple de réalisation de cette machine, l'appareil de refroidissement est un ventilateur ou analogue fixé latéralement sur le châssis et délivrant un flux d'air de refroidissement tangentiel à la partie supérieure du châssis et à l'ensemble précité.

Selon un autre mode de réalisation, l'appareil de refroidissement est un ventilateur ou analogue disposé au-dessus de la source de lumière ultraviolette et délivrant un flux d'air de refroidissement orthogonal à la partie supérieure du châssis et à l'ensemble précités.

Dans ce dernier cas, le ventilateur précité peut être disposé au-dessus d'une batterie de ventilateurs de refroidissement de la source de lumière ultraviolette, elle-même disposée sous ladite batterie.

Ainsi, le refroidissement simultané des lampes ultraviolettes et de la plaque flexographique avec ses éléments associés, sera avantageusement réalisé.

Mais d'autres avantages et caractéristiques de l'invention apparaîtront mieux dans la description détaillée qui suit et se réfère aux dessins annexés, donnés uniquement à titre d'exemple, et dans lesquels :

La figure 1 est une vue très schématique en élévation d'une machine conforme aux principes de l'invention.

La figure 2 est encore une vue en élévation très schématique, mais montrant un autre mode de réalisation de cette machine.

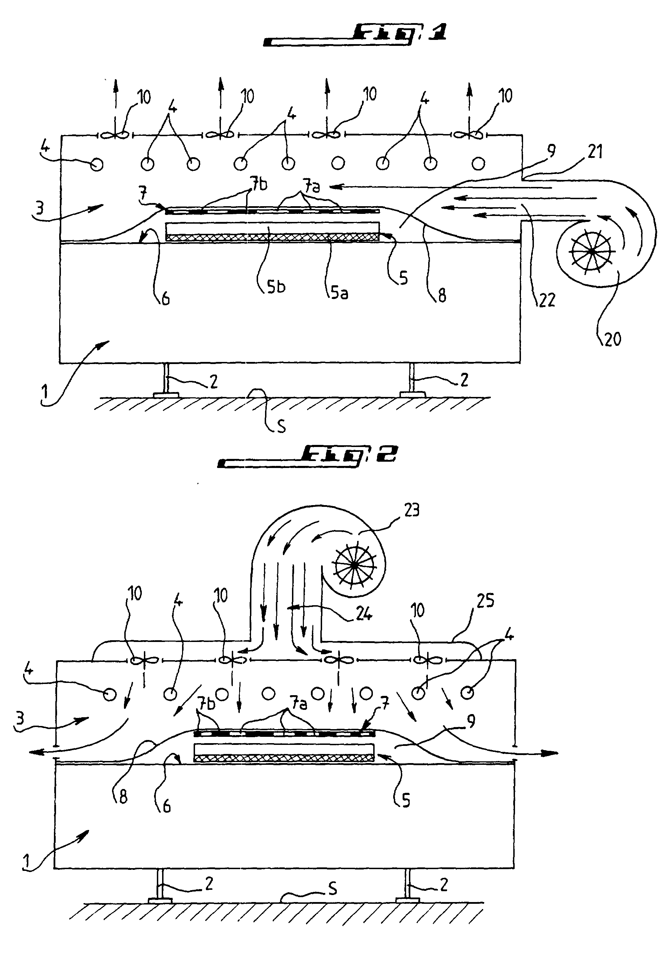

On voit sur les figures 1 et 2 qu'une machine pour insoler des plaques en photopolymère comprend essentiellement un châssis 1 reposant par l'intermédiaire de pieds 2 sur le sol S, lequel châssis comprend et est surmonté par un élément en forme de capot ou analogue 3 contenant une source de lumière ultraviolette formant, suivant l'exemple représenté, une rampe de lampes repérées en 4.

La rampe 4 permet l'insolation par la lumière ultraviolette, d'une plaque 5 en matériau photopolymère placée en dessous du capot 3 sur la partie supérieure 6 du châssis 1 de la machine. La plaque 5 se compose généralement d'une base 5a en polyester et d'une couche 5b en polymère photosensible.

Sur la plaque 5 est disposé un film négatif 7 comportant des zones transparentes 7a et opaques 7b qui seront donc traversées ou non par la lumière ultraviolette émanant de la rampe de lampes 4 pour insoler ou non la couche 5b de polymère photosensible qui, après lavage au solvant et séchage, comportera les reliefs désirés pour l'impression.

Enfin, l'ensemble film négatif 7 et plaque flexographique 5 sera maintenu sous vide sur la partie supérieure 6 du châssis 1 grâce à une membrane transparente 8 définissant entre elle et la partie supérieure 6 du châssis 1 un espace repéré en 9.

On a montré en 10 sur les figures une batterie de ventilateurs portée par le capot 3 du châssis 1 et susceptible de refroidir quelque peu la rampe de lampes ultraviolettes 4.

Toutes les dispositions ci-dessus font partie de l'état connu de la technique et ne nécessitent pas d'explications complémentaires.

Conformément à l'invention, la machine qui vient d'être décrite est équipée d'au moins un appareil de refroidissement de la partie supérieure 6 du châssis 1 au niveau de l'ensemble constitué par la membrane 8, le film négatif 7, et la plaque 5 en matériau photopolymère.

Cet appareil qui peut être d'un type quelconque (air climatisé ou non, air pulsé pré-refroidi ou non etc...) évitera avantageusement la formation d'une poche de gaz dans l'espace 9 entre la membrane 8 et la partie supérieure 6 du châssis 1, en raison de la chaleur engendrée par la rampe de lampes ultraviolettes 4, étant entendu que la batterie de petits ventilateurs 10 de refroidissement de cette lampe est inefficace pour éviter la formation de la poche de gaz en question.

Suivant l'exemple de réalisation représenté sur la figure 1, l'appareil de refroidissement est un ventilateur 20 qui est fixé latéralement sur le châssis 1, plus précisément sur le capot 3 faisant partie du châssis et le surmontant, comme on le voit en 21.

Ainsi, le ventilateur 20 sera apte à délivrer un flux 22 d'air de refroidissement sensiblement tangentiel à la partie supérieure du châssis 6 et donc à l'ensemble constitué par la membrane 8, le film négatif 7 et la plaque en polymère photosensible 5.

Suivant un autre mode de réalisation, comme on le voit clairement sur la figure 2, l'appareil de refroidissement est encore constitué par un ventilateur 23, mais qui est ici disposé au-dessus de la rampe 4 de lumière ultraviolette, de façon à délivrer un flux 24 d'air de refroidissement sensiblement orthogonal à la partie supérieure 6 du châssis 1 et donc à l'ensemble membrane 8, film négatif 7, plaque en photopolymère 5 reposant sur ladite partie supérieure.

Plus précisément, le ventilateur 23 est, à sa sortie, muni d'une jupe ou analogue 25 qui est fixée sur le capot 3 du châssis 1 au-dessus de la batterie de ventilateurs 10 de refroidissement des lampes ultraviolettes 4.

Ainsi, grâce à une telle disposition, on refroidira de manière efficace et simultanément la rampe de lampes 4 ainsi que l'ensemble membrane 8, film 7, plaque en polymère photosensible 5, reposant sur la partie supérieure 6 du châssis 1.

On a donc réalisé suivant l'invention une machine pour insoler des plaques en photopolymère qui ne risque aucunement de provoquer des perturbations au niveau des reliefs sur la plaque de polymère photosensible 5 en raison de l'énergie rayonnée par les lampes ultraviolettes insolant ladite plaque.

Bien entendu, l'invention n'est nullement limitée aux modes de réalisation décrits et illustrés qui n'ont été donnés qu'à titre d'exemple.

C'est ainsi que les lampes de lumière ultraviolette peuvent être agencées de façon quelconque et prévues suivant un nombre quelconque, de même que l'appareil de refroidissement équipant la machine peut être d'un type quelconque.

C'est dire que l'invention comprend tous les équivalents techniques des moyens décrits ainsi que leurs combinaisons si celles-ci entrent dans le cadre des revendications qui suivent.

## Revendications

1. Machine perfectionnée pour insoler des plaques en photopolymère pour l'impression flexographique et du type comprenant un châssis (1) au-dessus duquel est située au moins une source de lumière ultraviolette (4) susceptible d'insoler une plaque en photopolymère (5), reposant sur ledit châssis, à travers un film négatif (7) maintenu sous vide avec ladite plaque sur le châssis (1) à l'aide d'une membrane transparente (8), **caractérisée en ce qu'**elle est munie d'au moins un ventilateur de refroidissement (20) de la partie supérieure (6) du châssis (1) comportant l'ensemble membrane (8) - film négatif (7) - plaque en photopolymère (5), lequel ventilateur est fixé latéralement sur ledit châssis pour délivrer un flux (22) d'air de refroidissement tangentiel à la partie supérieure (6) du châssis (1) et à l'ensemble (8, 7 , 5) précité.

2. Machine perfectionnée pour insoler des plaques en photopolymère pour l'impression flexographique et du type comprenant un châssis (1) au-dessus duquel est située au moins une source de lumière ultraviolette (4) susceptible d'insoler une plaque en photopolymère (5), reposant sur ledit châssis, à travers un film négatif (7) maintenu sous vide avec ladite plaque sur le châssis (1) à l'aide d'une membrane transparente (8), **caractérisée en ce qu'**elle est munie d'un ventilateur de refroidissement (23) disposé au-dessus de la source de lumière ultraviolette (4) et délivrant un flux (24) d'air de refroidissement orthogonal à la partie supérieure (6) du châssis (1) et à l'ensemble membrane (8) - film négatif (7) - - plaque en photopolymère (5) que comporte la partie supérieure (6) du châssis (1), lequel ventilateur (23) est disposé au-dessus d'une batterie de ventilateurs (10) de refroidissement de la source de lumière ultraviolette (4) elle -même disposée sous ladite batterie.

## Patentansprüche

1. Perfektionierte Maschine zum der Sonne Aussetzen von Platten aus Photopolymer zum Flexodruck und von der Art, umfassend einen Rahmen (1), über dem sich wenigstens eine ultraviolette Lichtquelle (4) befindet, die geeignet ist, eine auf besagtem Rahmen aufliegende Platte aus Photopolymer (5) durch einen negativen Film (7) dem Sonnenlicht auszusetzen, der mit besagter Platte auf dem Rahmen (1) mittels einer transparenten Membran (8) unter Vakuum gehalten wird, **dadurch gekennzeichnet, daß** sie wenigstens mit einem Ventilator zum Abkühlen (20) des oberen Teils (6) des Rahmens (1) versehen ist, der den Aufbau Membran (8)-negativer Film (7) - Platte aus Photopolymer (5) umfaßt, wobei besagter Ventilator lateral auf besagtem Rahmen befestigt ist, um einen Luftstrom (22) zum tangentialen Abkühlen im oberen Teil (6) des Rahmens (1) und im vorgenannten Aufbau (8, 7, 5) zu liefern.

2. Perfektionierte Maschine zum der Sonne Aussetzen von Platten aus Photopolymer zum Flexodruck und von der Art, umfassend einen Rahmen (1), über dem sich wenigstens eine ultraviolette Lichtquelle (4) befindet, die geeignet ist, eine auf besagtem Rahmen aufliegende Platte aus Photopolymer (5) durch einen negativen Film (7) dem Sonnenlicht auszusetzen, der mit besagter Platte auf dem Rahmen (1) mittels einer transparenten Membran (8) unter Vakuum gehalten wird, **dadurch gekennzeichnet, daß** sie wenigstens mit einem Ventilator zum Abkühlen (23) versehen ist, der oberhalb der ultravioletten Lichtquelle (4) angeordnet ist und einen Luftstrom (24) zum orthogonalen Abkühlen des Rahmens (1) auf dem oberen Teil und des Aufbaus Membran (8) - negativer Film (7) - Platte aus Photopolymer (5) zu liefern, den der obere Teil (6) des Rahmens (1) umfaßt, wobei der Ventilator (23) oberhalb einer Batterie Ventilatoren (10) zum Abkühlen der ultravioletten Lichtquelle (4) angeordnet ist, die ihrerseits auf besagter Batterie angeordnet ist.

## Claims

1. Improved apparatus for exposing photopolymer plates for flexographic printing and of the type comprising a frame (1) above which at least one ultraviolet light source (4) is located for exposing a photopolymer plate (5), lying on said frame, through a negative film (7) which is maintained under vacuum with said plate on the frame (1) by means of a transparent membrane (8), **characterized in that** there is provided at least one fan (20) for cooling the upper part (6) of the frame (1) comprising the assembly of membrane (8) - negative film (7)-photopolymer plate (5), which fan is laterally fixed to said frame for supplying a flow (22) of cooling air tangential to the upper portion (6) of the frame (1) and to the above-mentioned assembly (8, 7, 5).

2. Improved apparatus for exposing photopolymer plates for flexographic printing and of the type comprising a frame (1) above which at least one ultraviolet light source (4) is located for exposing a photopolymer plate (5), lying on said frame, through a negative film (7) which is maintained under vacuum with said plate on the frame (1) by means of a transparent membrane (8), **characterized in that** there is provided a cooling fan (23) arranged above the ultraviolet light source (4) and supplying a flow (24) of cooling air orthogonal to the upper portion (6) of the frame (1) and to the assembly of membrane (8) - negative film (7) - photopolymer plate (5) comprised by the upper portion (6) of the frame (1), which fan (23) is arranged above a bank of fans (10) for cooling the ultraviolet light source (4) which is itself arranged under said bank.
